# EUROPÄISCHE PATENTSCHRIFT

(11) **EP 2 698 049 B1**
(45) Veröffentlichungstag und Bekanntmachung des Hinweises auf die Patenterteilung: **30.09.2015**
(21) Anmeldenummer: 12714250.3
(22) Anmeldetag: 20.03.2012
(51) Int. Cl.: H05K 7/14

(54) **LEISTUNGSELEKTRONISCHES SCHALTSYSTEM**
POWER ELECTRONIC SWITCHING SYSTEM
SYSTÈME DE COMMUTATION ÉLECTRONIQUE DE PUISSANCE

(30) Priorität: 14.04.2011 DE 202011005290 U
(43) Veröffentlichungstag der Anmeldung: 19.02.2014
(73) Patentinhaber: ABB Technology AG, 8050 Zürich (CH)
(72) Erfinder: IORDANIDIS, Arthouros, CH-5400 Baden (CH); CRANGANU-CRETU, Bogdan, CH-5442 Fislisbach (CH); WEISS, Michael, CH-5405 Winterthur (CH); CHAUDHURI, Toufann, CH-1110 Morges (CH); VELTHUIS, Rudi, 79787 Lauchringen (DE)
(74) Vertreter: ABB Patent Attorneys
(86) Internationale Anmeldenummer: PCT/EP2012/054914
(87) Internationale Veröffentlichungsnummer: WO 2012/139863

(56) Entgegenhaltungen:
- WO-A1-93/13587
- DE-A1-102008 030 640
- US-A1- 2004 201 972
- US-A1- 2010 118 493

## Beschreibung

### Technisches Gebiet

Die vorliegende Erfindung bezieht sich auf das Gebiet der Leistungselektronik. Sie betrifft ein leistungselektronisches Schaltsystem gemäss dem Oberbegriff des unabhängigen Anspruchs.

### Stand der Technik

Leistungselektronische Schaltsysteme sind heute hauptsächlich in Umrichterschaltungen für verschiedensten Anwendungen zu finden. Typischerweise umfasst ein solches leistungselektronisches Schaltsystem eine Vielzahl an Schalteinheiten und eine Montageeinheit, wobei die Montageeinheit eine Haltevorrichtung aufweist, an der die Schalteinheiten angeordnet sind. Ein gattungsgemässes leistungselektronisches Schaltsystem ist in der WO 2008/005485 A2 angegeben. Beispielsweise in Fig. 5A und Fig. 5B der WO 2008/005485 A2 weist die Haltevorrichtung mehrere Schienen auf, wobei immer zwei solcher Schienen eine Schalteinheit tragen und die Schalteinheit daran fixiert ist. Die Montageeinheit, die Haltevorrichtung und die Schienen sind typischerweise aus Metall und damit aus einem elektrisch leitenden Material.

Problematisch bei einem leistungselektronischen Schaltsystem nach der WO 2008/005485 A2 ist, dass die Schalteinheiten, insbesondere die Gehäuse der Schalteinheiten auf einem einheitlichen Spannungspotential liegen müssen, da es sonst zu unerwünschten Ausgleichströmen kommen würde. Ist es aber beispielsweise durch eine vorgegebene Anwendung notwendig, dass die Schalteinheiten, insbesondere die Gehäuse der Schalteinheiten auf unterschiedlichen Spannungspotentialen liegen, so ist dies mit einem leistungselektronischen Schaltsystem nach der WO 2008/005485 A2 nicht möglich. Desweiteren ist der Aufbau des leistungselektronischen Schaltsystems der WO 2008/005485 A2 kompliziert und benötigt viel Platz, da für jede Schalteinheit zwei Schienen notwendig sind, die zusätzlich an einer Rahmenstruktur befestigt werden müssen. Die Herstellung eines solchen leistungselektronischen Schaltsystems ist damit aufwendig, benötigt viel Zeit und Erfahrung bei der Montage und ist somit dementsprechend teuer.

### Darstellung der Erfindung

Aufgabe der Erfindung ist es deshalb, ein leistungselektronisches Schaltsystem anzugeben, welches es Schalteinheiten des Schaltsystems, insbesondere den Gehäusen der Schalteinheiten ermöglicht, untereinander unterschiedliche Spannungspotentiale aufzuweisen und welches zudem einfach und platzsparend zu realisieren und problemlos zu montieren ist. Diese Aufgabe wird durch die Merkmale des Anspruchs 1 gelöst. In den abhängigen Ansprüchen sind vorteilhafte Weiterbildungen der Erfindung angegeben.

Das erfindungsgemässe leistungselektronische Schaltsystem umfasst eine Vielzahl an Schalteinheiten und eine Montageeinheit, wobei die Montageeinheit eine Haltevorrichtung aufweist, an welcher Haltevorrichtung die Schalteinheiten angeordnet sind. Erfindungsgemäss weist die Haltevorrichtung nun ein Isolationsmaterial zur elektrischen Isolation der Haltevorrichtung gegenüber den Schalteinheiten und gegenüber den Schalteinheiten untereinander auf. Durch diese Haltevorrichtung kann vorteilhaft erreicht werden, dass die Schalteinheiten, insbesondere die Gehäuse der Schalteinheiten untereinander auf unterschiedlichen Spannungspotentialen liegen können, ohne dass unerwünschte Ausgleichströme fliessen. Mit Vorteil vermeidet die Haltevorrichtung auch mögliche Teilentladungen, welche aufgrund der vorstehend genannten unterschiedlichen Spannungspotentiale auftreten können. Desweiteren ist der Aufbau des erfindungsgemässen leistungselektronischen Schaltsystems durch die Montageinheit und deren Haltevorrichtung sehr einfach und platzsparend aufgebaut, da die Haltevorrichtung mehrere Schalteinheiten aufnehmen kann. Zudem ist das leistungselektronische Schaltsystem durch die Montageinheit und deren Haltevorrichtung entsprechend robust. Ferner ist die Realisierung und Herstellung des leistungselektronischen Schaltsystems schnell und problemlos möglich, da der Montageaufwand gering ist und die Montage ohne grössere Erfahrung erfolgen kann. Das erfindungsgemässe leistungselektronische Schaltsystem ist demzufolge sehr kostengünstig herzustellen.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnungen

Es zeigen:
- Fig. 1: eine schematische dreidimensionale Darstellung einer Ausführungsform eines erfindungsgemässen leistungselektronischen Schaltsystems,
- Fig. 2: eine Vorderansicht eines Ausschnitts der Ausführungsform des erfindungsgemässen leistungselektronischen Schaltsystems nach Fig. 1,
- Fig. 3: ein Ausschnitt der schematische dreidimensionale Darstellung der Ausführungsform des erfindungsgemässen leistungselektronischen Schaltsystems nach Fig. 1 und
- Fig. 4: eine schematische dreidimensionale Darstellung einer weiteren Ausführungsform des erfindungsgemässen leistungselektronischen Schaltsystems.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

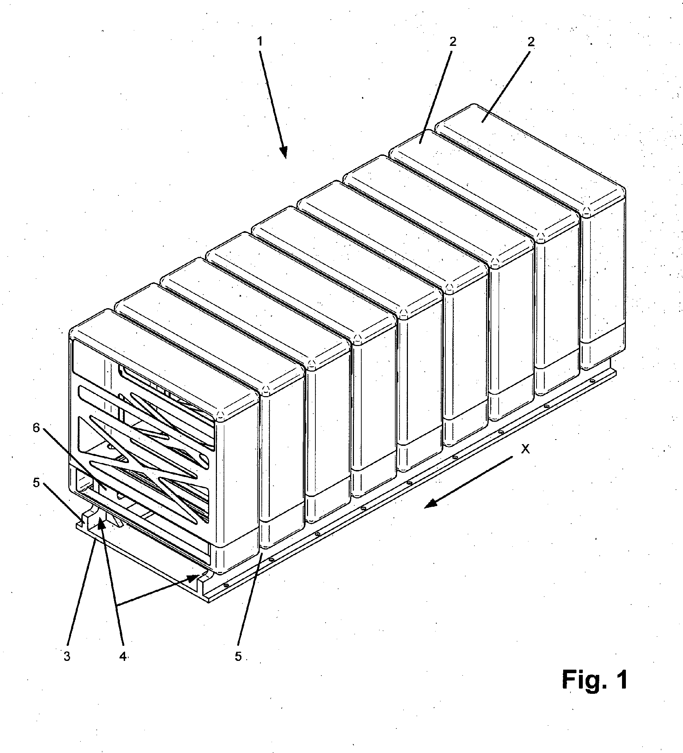

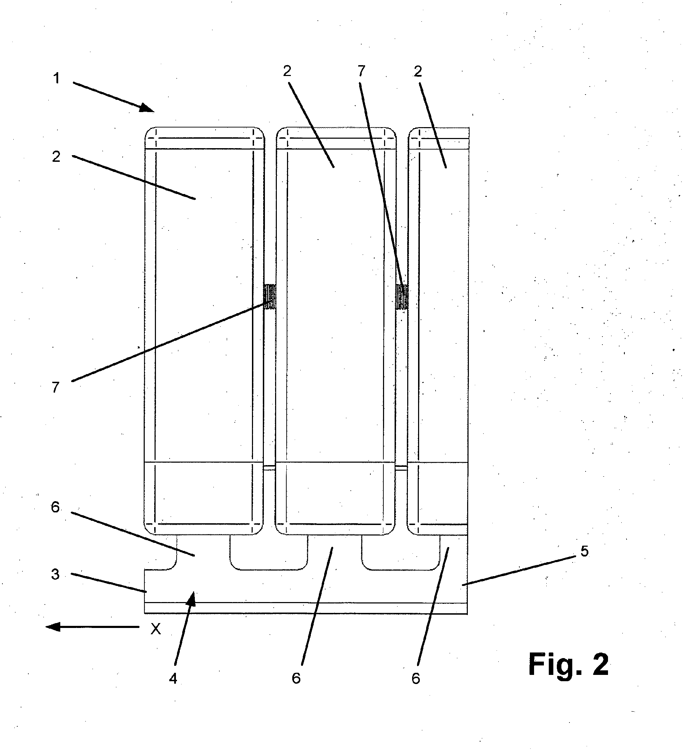

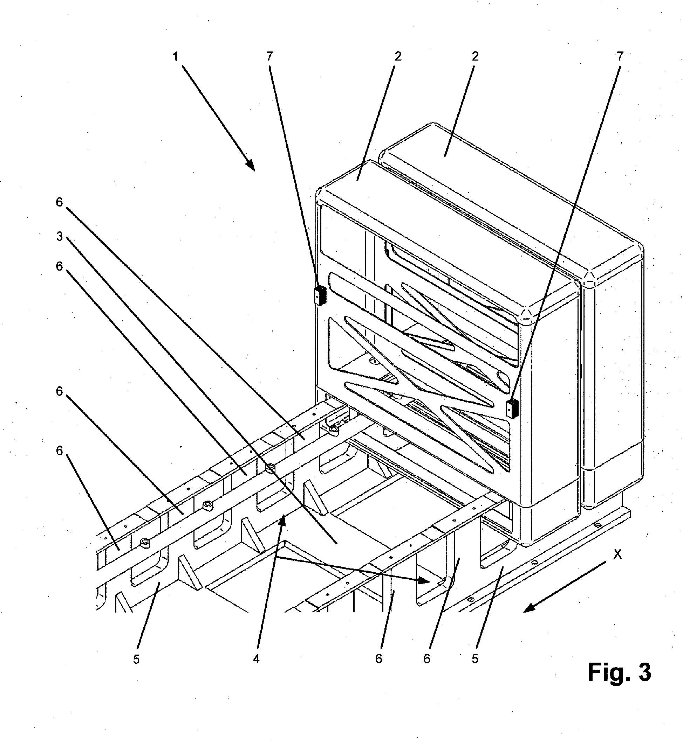

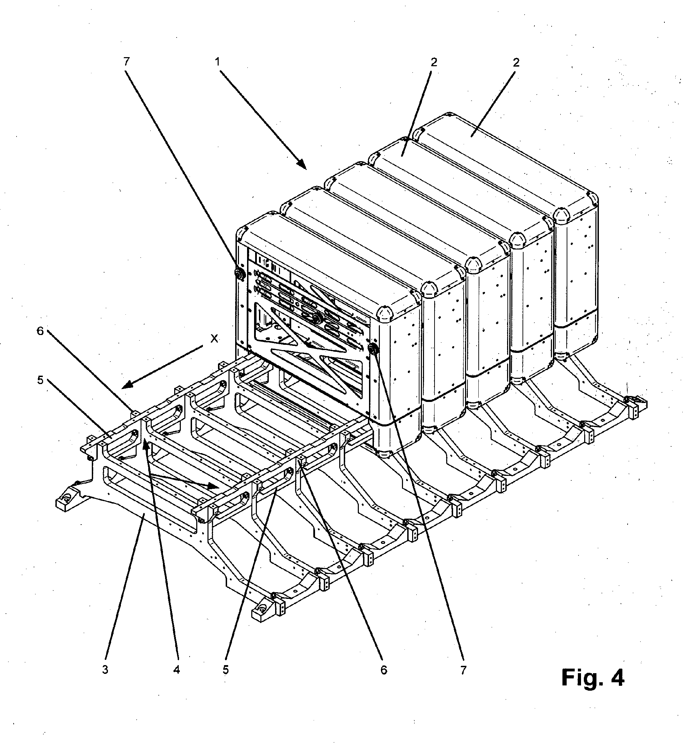

Fig. 1 zeigt eine schematische dreidimensionale Darstellung einer Ausführungsform eines erfindungsgemässen leistungselektronischen Schaltsystems 1. Ferner zeigt Fig. 2 eine Vorderansicht eines Ausschnitts der Ausführungsform des erfindungsgemässen leistungselektronischen Schaltsystems 1 nach Fig. 1. Darüber hinaus ist in Fig. 3 ein Ausschnitt der schematische dreidimensionale Darstellung der Ausführungsform des erfindungsgemässen leistungselektronischen Schaltsystems 1 nach Fig. 1 dargestellt. Fig. 4 zeigt schliesslich eine schematische dreidimensionale Darstellung einer weiteren Ausführungsform des erfindungsgemässen leistungselektronischen Schaltsystems 1. Das erfindungsgemässe leistungselektronische Schaltsystem 1 umfasst gemäss Fig. 1 eine Vielzahl an Schalteinheiten 2. Eine solche Schalteinheit 2 weist einen elektrischen Energiespeicher auf, der mit mindestens einem Schaltmodul verbunden ist. Der elektrische Energiespeicher und das mindestens eine Schaltmodul sind in Fig. 1, Fig. 2, Fig. 3 und Fig. 4 der Übersichtlichkeit halber nicht dargestellt. Das vorstehend genannte Schaltmodul umfasst vorzugsweise einen oder mehrere ansteuerbare Leistungshalbleiterschalter. Im Falle mehrerer ansteuerbarer Leistungshalbleiterschalter sind diese beispielsweise zu einer Halbbrückenschaltung oder einer Vollbrückenschaltung verschaltet. Es sei darauf hingewiesen, dass jegliche, dem Fachmann bekannte Verschaltungen der ansteuerbaren Leistungshalbleiterschalter denkbar sind. Der jeweilige ansteuerbare Leistungshalbleiterschalter ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar, einen ansteuerbaren Leistungshalbleiterschalter beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden.

Gemäss Fig. 1 umfasst das leistungselektronische Schaltsystem 1 zudem eine Montageeinheit 3, wobei die Montageeinheit 3 eine Haltevorrichtung 4 aufweist, an welcher Haltevorrichtung 4 die Schalteinheiten 2 angeordnet sind. Erfindungsgemäss weist die Haltevorrichtung 4 nun ein Isolationsmaterial zur elektrischen Isolation der Haltevorrichtung 4 gegenüber den Schalteinheiten 2 und gegenüber den Schalteinheiten 2 untereinander auf. Durch diese Haltevorrichtung 4 wird mit Vorteil erreicht, dass die Schalteinheiten 2, insbesondere die Gehäuse der Schalteinheiten 2 untereinander auf unterschiedlichen Spannungspotentialen liegen können, ohne dass unerwünschte Ausgleichströme fliessen. Die Haltevorrichtung 4 dient zudem der Vermeidung möglicher Teilentladungen, welche aufgrund der vorstehend genannten unterschiedlichen Spannungspotentiale auftreten können. Desweiteren ist der Aufbau des erfindungsgemässen leistungselektronischen Schaltsystems 1 durch die Montageinheit 3 und deren Haltevorrichtung 4 sehr einfach und platzsparend aufgebaut, da die Haltevorrichtung 4 mehrere Schalteinheiten 2 aufnehmen kann. Zudem ist das leistungselektronische Schaltsystem 1 durch die Montageinheit 3 und deren Haltevorrichtung 4 entsprechend robust. Die Realisierung und Herstellung des leistungselektrönischen Schaltsystems 1 ist ferner schnell und problemlos möglich, da der Montageaufwand gering ist und die Montage ohne grössere Erfahrung erfolgen kann. Das erfindungsgemässe leistungselektronische Schaltsystem 1 ist demnach äusserst kostengünstig herzustellen.

Selbstverständlich ist es auch denkbar, dass die gesamte Montageeinheit 3 ein Isolationsmaterial aufweist. ,

Vorzugsweise umfasst die Haltevorrichtung 4 zwei Schenkel 5 mit jeweils einer Vielzahl an Vorsprüngen 6 zur Aufnahme der jeweiligen Schalteinheit 2. Wie in Fig. 2 gezeigt, muss die jeweilige Schalteinheit 2 bei der Montage lediglich auf einen Vorsprung 6 des einen und des anderen Schenkels 5 aufgesteckt werden und danach an den zugehörigen Vorsprüngen 6 der Schenkel 5 fixiert werden. Die Fixierung erfolgt mit in Fig. 3 angedeuteten Plattenelementen. Wie in Fig. 1, Fig. 2 und Fig. 3 gezeigt, sind die Vorsprünge 6 des jeweiligen Schenkels 5 in Längsrichtung X des jeweiligen Schenkels 5 angeordnet. Bevorzugt sind die die Vorsprünge 6 eines Schenkels 5 dabei äquidistant beabstandet. Weiterhin entspricht die Anzahl der Vorsprünge 6 des einen Schenkels 5 der Anzahl Vorsprünge 6 des anderen Schenkels 5. Desweiteren sind die Schenkel 5 vorteilhaft im wesentlichen parallel zueinander angeordnet.

Gemäss Fig. 1, Fig. 2, Fig. 3 und Fig. 4 sind die Schalteinheiten 2 entlang beider Schenkel 5 nebeneinander angeordnet, wobei jeweils benachbarte Schalteinheiten 2 mittels mindestens eines Abstandselementes 7 zueinander beanstandet und miteinander verbunden sind. Vorzugsweise weist das Abstandselement 7 ein Isolationsmaterial zur elektrischen Isolation der mit dem Abstandselement 7 verbundenen Schalteinheiten 2 auf. Demzufolge dient das Abstandselement 7 einerseits der elektrischen Isolation benachbarter Schalteinheiten 2 gegeneinander und andererseits der Fixierung benachbarter Schaleinheiten 2 miteinander, so dass ein kompakter, gegen mechanische Schwingungen weitestgehend unempfindlicher und damit insgesamt robuster Verbund der Schalteinheiten 2 entsteht. Das erfindungsgemässe Schaltsystem 1 eignet sich somit für Anwendungen in einem rauen Umfeld und ist beispielsweise prädestiniert für Traktionsanwendungen.

Es ist denkbar, dass die Montageeinheit 3 einstückig ausgebildet ist. In diesem Fall ist die Montageeinheit 3 beispielsweise durch Giessen oder durch ein anderes Formgebungsverfahren eines Isolationsmaterials sehr einfach herstellbar.

### Bezugszeichenliste

- 1: leistungselektronisches Schaltsystem
- 2: Schalteinheit
- 3: Montageeinheit
- 4: Haltevorrichtung
- 5: Schenkel
- 6: Vorsprung
- 7: Abstandselement

## Patentansprüche

1. Leistungselektronisches Schaltsystem (1) mit einer Vielzahl an Schalteinheiten (2) und mit einer Montageeinheit (3), wobei die Montageeinheit (3) eine Haltevorrichtung (4) aufweist, an welcher Haltevorrichtung (4) die Schalteinheiten (2) angeordnet sind, **dadurch gekennzeichnet,**
**dass** die Haltevorrichtung (4) ein Isolationsmaterial zur elektrischen Isolation der Haltevorrichtung (4) gegenüber den Schalteinheiten (2) und gegenüber den Schalteinheiten (2) untereinander aufweist, und
**dass** die Haltevorrichtung (4) zwei Schenkel (5) mit jeweils einer Vielzahl an Vorsprüngen (6) zur Aufnahme der jeweiligen Schalteinheit (2) umfasst.

2. Leistungselektronisches Schaltsystem (1) nach Anspruch 1, **dadurch gekennzeichnet, dass** die Vorsprünge (6) des jeweiligen Schenkels (5) in Längsrichtung (X) des jeweiligen Schenkels (5) angeordnet sind.

3. Leistungselektronisches Schaltsystem (1) nach Anspruch 1 oder 2, **dadurch gekennzeichnet, dass** die Anzahl Vorsprünge (6) des einen Schenkels (5) der Anzahl Vorsprünge (6) des anderen Schenkels (5) entspricht.

4. Leistungselektronisches Schaltsystem (1) nach einem der Anspruch 1 bis 3, **dadurch gekennzeichnet, dass** die jeweilige Schalteinheit (2) an den zugehörigen Vorsprüngen (5) fixiert ist.

5. Leistungselektronisches Schaltsystem (1) nach einem der Ansprüche 1 bis 4, **dadurch gekennzeichnet, dass** die Schenkel (5) im wesentlichen parallel zueinander angeordnet sind.

6. Leistungselektronisches Schaltsystem (1) nach einem der Ansprüche 1 bis 5, **dadurch gekennzeichnet, dass** die Schalteinheiten (2) entlang beider Schenkel (5) nebeneinander angeordnet sind, wobei jeweils benachbarte Schalteinheiten (2) mittels mindestens eines Abstandselementes (7) zueinander beanstandet und miteinander verbunden sind.

7. Leistungselektronisches Schaltsystem (1) nach Anspruch 6, **dadurch gekennzeichnet, dass** das Abstandselement (7) ein Isolationsmaterial zur elektrischen Isolation der mit dem Abstandselement (7) verbundenen Schalteinheiten (2) aufweist.

8. Leistungselektronisches Schaltsystem (1) nach einem der Ansprüche 1 bis 7, **dadurch gekennzeichnet, dass** die Montageeinheit (3) einstückig ausgebildet ist.

## Claims

1. Power-electronic switching system (1) having a large number of switching units (2) and having a mounting unit (3), wherein the mounting unit (3) has a holding apparatus (4), on which holding apparatus (4) the switching units (2) are arranged,
**characterized**
**in that** the holding apparatus (4) comprises an insulation material for electrically insulating the holding apparatus (4) from the switching units (2) and the switching units (2) from one another, and
**in that** the holding apparatus (4) comprises two limbs (5) each having a plurality of projections (6) for the purpose of holding the respective switching unit (2).

2. Power-electronic switching system (1) according to Claim 1, **characterized in that** the projections (6) of the respective limb (5) are arranged in the longitudinal direction (X) of the respective limb (5).

3. Power-electronic switching system (1) according to Claim 1 or 2, **characterized in that** the number of projections (6) of one limb (5) corresponds to the number of projections (6) of the other limb (5).

4. Power-electronic switching system (1) according to one of Claims 1 to 3, **characterized in that** the respective switching unit (2) is fixed to the associated projections (6).

5. Power-electronic switching system (1) according to one of Claims 1 to 4, **characterized in that** the limbs (5) are arranged substantially parallel to one another.

6. Power-electronic switching system (1) according to one of Claims 1 to 5, **characterized in that** the switching units (2) are arranged next to one another along the two limbs (5), wherein respectively adjacent switching units (2) are separated from one another and connected to one another by means of at least one spacer element (7) .

7. Power-electronic switching system (1) according to Claim 6, **characterized in that** the spacer element (7) comprises an insulation material for electrically insulating the switching units (2) which are connected to the spacer element (7).

8. Power-electronic switching system (1) according to one of Claims 1 to 7, **characterized in that** the mounting unit (3) is of integral design.

## Revendications

1. Système électronique (1) de commutation de puissance présentant plusieurs unités de commutation (2) et une unité de montage (3), l'unité de montage (3) présentant un ensemble de maintien (4) et les unités de commutation (2) étant disposées sur l'ensemble de maintien (4), **caractérisé en ce que**
l'ensemble de maintien (4) présente un matériau isolant qui isole électriquement l'ensemble de maintien (4) par rapport aux unités de commutation (2) et les unités de commutation (2) les unes par rapport aux autres et
**en ce que** l'ensemble de maintien (4) comporte deux branches (5) qui comptent chacune plusieurs saillies (6) de réception des différentes unités de commutation (2).

2. Système électronique (1) de commutation de puissance selon la revendication 1, **caractérisé en ce que** les saillies (6) de chaque branche (5) sont disposées dans le sens de la longueur (X) de la branche (5) concernée.

3. Système électronique (1) de commutation de puissance selon les revendications 1 ou 2, **caractérisé en ce que** le nombre de saillies (6) d'une branche (5) correspond au nombre des saillies (6) d'une autre branche (5).

4. Système électronique (1) de commutation de puissance selon l'une des revendications 1 à 3, **caractérisé en ce que** chaque unité de commutation (2) est fixée sur les saillies (6) associées.

5. Système électronique (1) de commutation de puissance selon l'une des revendications 1 à 4, **caractérisé en ce que** les branches (5) sont disposées essentiellement en parallèle l'une à l'autre.

6. Système électronique (1) de commutation de puissance selon l'une des revendications 1 à 5, **caractérisé en ce que** les unités de commutation (2) sont disposées les unes à côté des autres le long des deux branches (5), les unités de commutation (2) voisines étant maintenues à distance l'une de l'autre et reliées l'une à l'autre au moyen d'au moins un élément d'écartement (7).

7. Système électronique (1) de commutation de puissance selon la revendication 6, **caractérisé en ce que** l'élément d'écartement (7) présente un matériau isolant qui assure l'isolation électrique des unités de commutation (2) reliées à l'élément d'écartement (7).

8. Système électronique (1) de commutation de puissance selon l'une des revendications 1 à 7, **caractérisé en ce que** l'unité de montage (3) est réalisée en une seule pièce.
